(19)

Europäisches
Patentamt
European
Patent Office
Office européen
des brevets

(11) **EP 3 767 014 A1**

(12) **EUROPEAN PATENT APPLICATION**
published in accordance with Art. 153(4) EPC

(43) Date of publication:
**20.01.2021 Bulletin 2021/03**

(21) Application number: **19766951.8**

(22) Date of filing: **18.02.2019**

(51) Int Cl.:
**C30B 29/36** *(2006.01)*   **C30B 23/06** *(2006.01)*

(86) International application number:
**PCT/JP2019/005730**

(87) International publication number:
**WO 2019/176446 (19.09.2019 Gazette 2019/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.03.2018 JP 2018048559**

(71) Applicant: **Shin-Etsu Handotai Co., Ltd.
Tokyo 100-0004 (JP)**

(72) Inventors:
• IKEDA Hitoshi
  **Annaka-shi, Gunma 379-0196 (JP)**
• MATSUMOTO Yuichi
  **Annaka-shi, Gunma 379-0196 (JP)**
• EBIHARA Masato
  **Annaka-shi, Gunma 379-0196 (JP)**
• TAKAHASHI Toru
  **Annaka-shi, Gunma 379-0196 (JP)**

(74) Representative: **Wibbelmann, Jobst
Wuesthoff & Wuesthoff
Patentanwälte PartG mbB
Schweigerstrasse 2
81541 München (DE)**

(54) **PRODUCTION METHOD OF SILICON CARBIDE SINGLE CRYSTAL**

(57)     The present invention provides a method for manufacturing a silicon carbide single crystal by sublimating a silicon carbide raw material in a growth container to grow a silicon carbide single crystal on a seed crystal substrate. The seed crystal substrate used is a substrate having a {0001} plane with an off angle of 1° or less as a surface to be placed on the growth container, and a convex-shaped end face of a grown ingot as a crystal growth surface. A diameter of the seed crystal substrate is 80% or more of an inner diameter of the growth container. Thereby, provided is a method for manufacturing a silicon carbide single crystal while enabling high straight-body percentage and little formation of different polytypes even in growth with no off-angle control, i.e., the growth is directed onto a basal plane which is not inclined from a C-axis <0001>.

[FIG. 1]

**Description**

TECHNICAL FIELD

The present invention relates to a method for manufacturing silicon carbide in which a silicon carbide crystal is grown by a sublimation method.

BACKGROUND ART

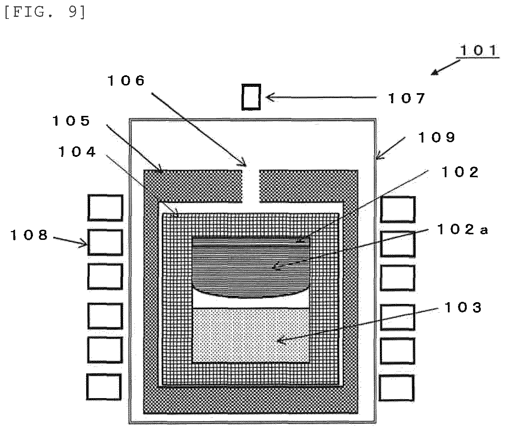

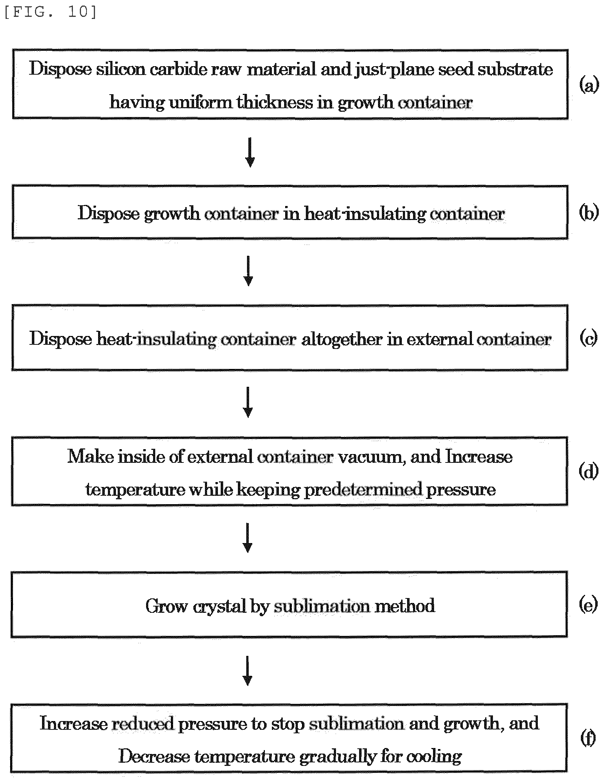

Recently, inverter circuits have been commonly used in electric vehicles and electric air-conditioners. This creates demands for semiconductor crystal of silicon carbide (hereinafter may also be referred to as SiC) because of the properties of less power loss and higher breakdown voltage in devices than those using semiconductor Si crystal.
As a typical and practical method for growing a crystal with a high melting point or a crystal that is difficult to grow by liquid phase growth such as SiC, a sublimation method exists. In this method, a solid raw material is sublimated in a container at a high temperature around 2000°C or higher, and a crystal is grown on a seed crystal located on the opposite side (Patent Document 1). However, SiC crystal growth requires high temperature for the sublimation, and the growth apparatus requires temperature control at the high temperature. Moreover, to stabilize the pressure of the sublimated substance, it is necessary to steadily control the pressure inside the container. Further, SiC crystal growth depends on the sublimation rate, and the growth rate is relatively quite slow in comparison with Czochralski method for Si, LPE manufacturing method for GaAs and so forth, for example. Hence, long time is required for the growth. Fortunately, the developments of control units, computers, personal computers, and so forth nowadays enable long-term steady adjustments of pressure and temperature.
Specifically, a method for growing SiC by sublimation is performed using an apparatus 101 for growing a silicon carbide single crystal as shown in FIG. 9. A silicon-carbide solid raw material 103 is put in a growth container 104, and heated with a heater (radio-frequency heating coil) 108 for crystal growth. Thus, a grown crystal 102a is formed on a plate-like seed substrate (just-plane seed wafer) 102 disposed in the growth container 104.
The growth container 104 is disposed in a vacuum quartz tube or a vacuum chamber, and filled with a gas with low reactivity once. The atmosphere is lower than the atmospheric pressure so as to increase the SiC sublimation rate.
Outside the growth container 104, a heat-insulating material (heat-insulating container) 105 is disposed. At least one hole (upper-portion temperature measurement hole) 106 for measuring the temperature with a pyrometer (temperature-measurement sensor) 107 is provided to a portion of the heat-insulating material 105. The growth container 104 is mainly made of a carbon material and is air permeable, and the pressures inside and outside the container are equal. The silicon carbide raw material 103 is disposed at a lower portion of the growth container 104. The material 103 is solid, and sublimates at high temperature under reduced pressure. The sublimated material grows as the single crystal (grown crystal) 102a on the seed crystal substrate (seed wafer) 102 located on the opposite side.
Here, a conventional method for manufacturing a silicon carbide single crystal by using the above-described manufacturing apparatus will be described with reference to FIG. 10. First, as described in FIG. 10(a), the silicon carbide raw material 103 and the just-plane seed substrate (just-plane seed wafer) 102 having a uniform thickness are disposed in the growth container 104. Next, as described in FIG. 10(b), the growth container 104 is disposed in the heat-insulating container 105. Next, as described in FIG. 10(c), the heat-insulating container 105 as a whole is disposed in an external container 109. Next, as described in FIG. 10(d), the inside of the external container 109 is made vacuum, and the temperature is raised to 2000 to 2300°C while a predetermined pressure is being kept (for example, 1 to 20 Torr (1.3 to 26 hPa)). Next, as described in FIG. 10(e), the silicon carbide single crystal (grown crystal) 102a is grown on the seed crystal substrate (seed wafer) 102 by sublimation method. Finally, as described in FIG. 10(f), the pressure is increased to stop the sublimation and the growth, and the temperature is gradually lowered for cooling.
Meanwhile, SiC single crystal includes cubic, hexagonal crystals, for example. Further, among hexagonal crystals, 4H, 6H, and so forth are known as typical polytypes.
In many cases, single crystal grows on the same type like 4H grows on a 4H type (Patent Document 2).

CITATION LIST

PATENT LITERATURE

Patent Document 1: Japanese Unexamined Patent Application Publication No. 2000-191399
Patent Document 2: Japanese Unexamined Patent Application Publication No. 2005-239465
Patent Document 3: Japanese Unexamined Patent Application Publication No. 2010-126380

SUMMARY OF INVENTION

TECHNICAL PROBLEM

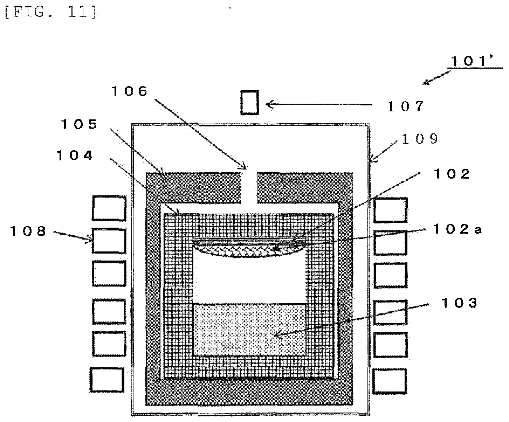

However, in a case where a seed substrate having a crystal orientation of a {0001} plane with no off angle (what is called just plane with an off angle of 1° or less) is used, there is a problem that a crystal started to grow is likely to be disordered (crystallites of different polytypes) (see FIG. 11). FIG. 11 shows an apparatus 101' for growing a silicon carbide single crystal while the growth is in the initial stage.

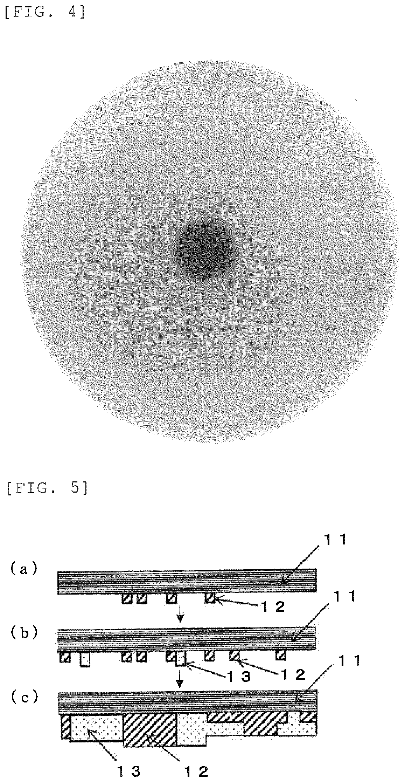

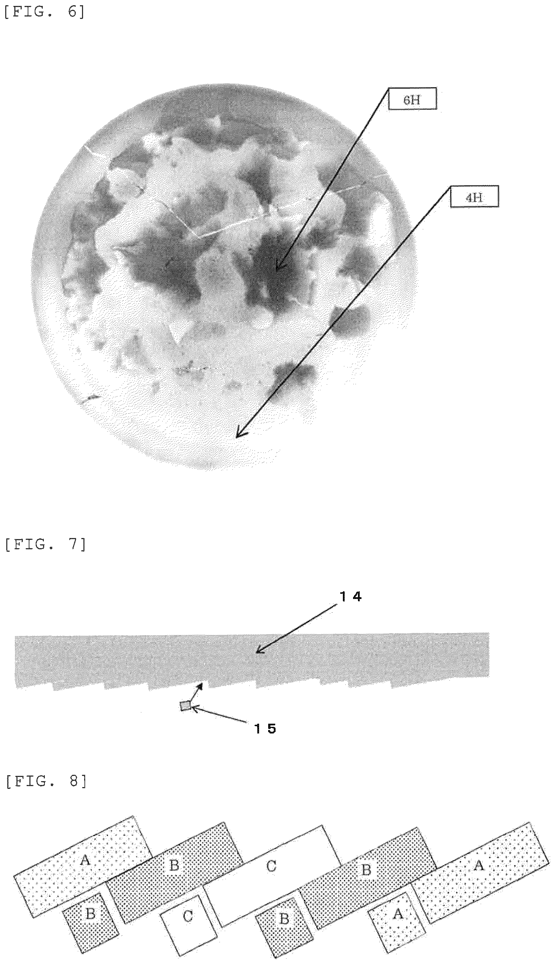

Moreover, when a SiC hexagonal crystal is grown on a seed substrate having a just plane with no off angle, for example, a seed substrate with a surface having a plane parallel to a hexagonal basal plane, some polytypes of the original seed are often formed during the random two-dimensional nucleation in the initial growth stage; for example, 6H structure is formed in addition to 4H structure (see FIGs. 5, 6). Note that FIG. 5 shows states where a 4H structure 12 and a 6H structure 13 are grown on the (0111) plane as the just plane of a seed substrate 11 with 4H structure.

Like this example, if 4H structure is mixed with 6H structure as a different polytype, the value as a semiconductor is completely lost. This is because the properties such as breakdown voltage are greatly changed. In addition, cracking may also occur during slicing.

When a substrate having an off angle is used, the growth proceeds by step growth mechanism with relatively less disorder. FIG. 7 shows a step growth with an off angle being formed. FIG. 7 shows a state where a SiC source 15 enters on a seed substrate 14 having an off angle.

As often stated in textbooks of crystal growth, when carbon and silicon sources as raw materials enter a kink, the resultant keeps the 4H structure of the substrate and is hardly disordered.

A hexagonal crystal has three sites: A, B, and C. This is caused by twisting of a bond at the C side relative to Si in the following general formula (1), thereby creating a position or axis where three atoms enter on a hexagonal basal plane. As shown in FIG. 8, layers are stacked in the order of ABCB in the 4H structure. In the 6H structure, layers are stacked in the order of ABCACB.

$$> \mathrm{S\ i = C} < \quad \cdots \cdots \quad (1)$$

Thus, in the case of a seed (seed crystal substrate) having an off angle, even if the surface is flat, the growth can be started without modifying the polytype. In other words, even if the seed (seed crystal substrate) is flat, step is present on the flat growth surface. For this reason, it is relatively easy to achieve the growth without polytype modification through a mechanism called lateral growth or step growth.

In contrast, in the growth on a just plane, that is, a basal plane, the random two-dimensional nucleation and spiral growth intrinsic to SiC occur at many locations within the plane. Since the layered structure of the polytype is not exposed, the stacking order of the polytype is not preserved, so that small regions functioning like nuclei of seed crystals of different polytypes are developed, enlarged, and spread.

Nevertheless, when a seed (seed crystal substrate) with an off angle is used, the grown ingot does not have point symmetry, so that the percentage of the straight body (length of the straight body/full length) is low (i.e., the length of the straight body is short). This results in a problem of low wafer yield.

Meanwhile, Patent Document 3 discloses that an end face side of a grown silicon carbide single crystal is sliced to a predetermined thickness and used as an end face of a seed.

However, the studies by the present inventors have revealed that even when the seed crystal substrate as mentioned above is used, if the diameter of the seed crystal substrate is smaller than the inner diameter of the accommodation container, the effect of suppressing the formation of different polytypes is small.

The present invention has been made in view of the above-described problems. An object of the present invention is to provide a method for manufacturing a silicon carbide single crystal so that a silicon carbide single crystal can be manufactured with high straight-body percentage and little formation of different polytypes even in growth with no off-angle control, that is, the growth is directed onto a basal plane which is hardly inclined from a C-axis <0001>.

SOLUTION TO PROBLEM

To achieve the object, the present invention provides a method for manufacturing a silicon carbide single crystal by sublimating a silicon carbide raw material in a growth container to grow a silicon carbide single crystal on a seed crystal substrate, wherein
a substrate used as the seed crystal substrate comprises:

a {0001} plane with an off angle of 1° or less as a surface to be placed on the growth container; and

a convex-shaped end face of a grown ingot as a crystal growth surface, and

a diameter of the seed crystal substrate is 80% or more of an inner diameter of the growth container.

Utilizing such a grown ingot end face as the seed (seed crystal substrate) and setting the diameter of the seed crystal substrate to 80% or more of the inner diameter of the growth container make it possible to manufacture a silicon carbide single crystal with high straight-body percentage while suppressing formation of different polytypes.

ADVANTAGEOUS EFFECTS OF INVENTION

As described above, according to the present invention, an end face of a grown ingot is utilized as the seed crystal substrate, and the diameter of the seed crystal substrate is set to 80% or more of the inner diameter of the growth container. Thus, it is possible to manufacture a silicon carbide single crystal with high straight-body percentage while suppressing formation of different polytypes.

BRIEF DESCRIPTION OF DRAWINGS

FIG. 1 is a schematic cross-sectional view showing an example of an apparatus for growing a silicon carbide single crystal with which the inventive method for manufacturing a silicon carbide single crystal can be carried out (before a silicon carbide single crystal is grown).

FIG. 2 is a schematic cross-sectional view showing the apparatus for growing a silicon carbide single crystal with which the inventive method for manufacturing a silicon carbide single crystal can be carried out (the silicon carbide single crystal is being grown).

FIG. 3 is a flowchart showing the inventive method for manufacturing a silicon carbide single crystal.

FIG. 4 is a top view showing a state where no different polytype is formed in a silicon carbide single crystal of Example 1.

FIG. 5 shows schematic cross-sectional views illustrating states where different polytypes are formed on a just-plane seed.

FIG. 6 is a top view showing a state where different polytypes are formed on a just-plane seed.

FIG. 7 is a schematic cross-sectional view showing an initial state of single crystal growth when a substrate having an off angle is used as a seed crystal substrate.

FIG. 8 is a schematic cross-sectional view showing a state where a single crystal having a 4H structure is grown when a substrate having an off angle is used as a seed crystal substrate.

FIG. 9 is a schematic cross-sectional view showing a conventional apparatus for growing a silicon carbide single crystal.

FIG. 10 is a flowchart showing a conventional method for manufacturing a silicon carbide single crystal.

FIG. 11 is a schematic cross-sectional view showing the conventional apparatus for growing a silicon carbide single crystal (a silicon carbide single crystal is in an initial growth state).

DESCRIPTION OF EMBODIMENTS

Hereinafter, the present invention will be described in detail with reference to the drawings as an example of embodiments. However, the present invention is not limited thereto.

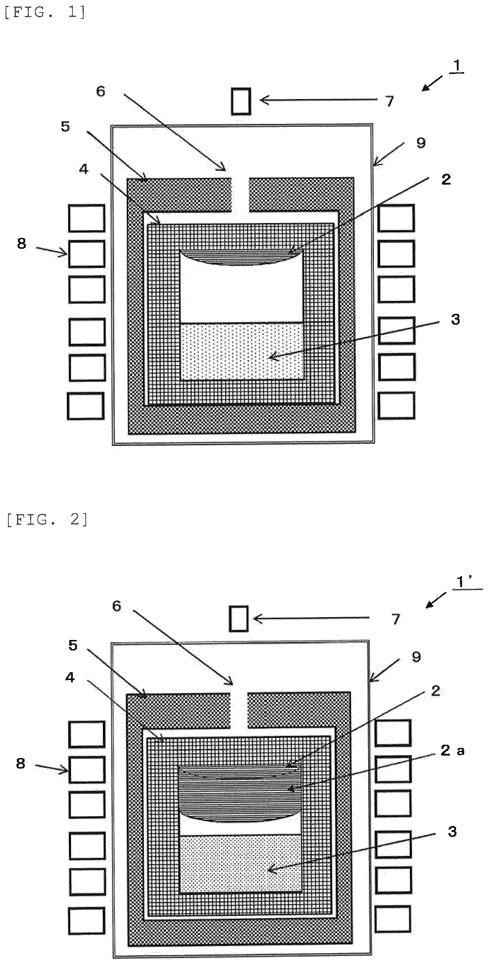

Herein below, a method for manufacturing a silicon carbide single crystal according to the present invention will be described with reference to Figs 1 to 3.

FIG. 1 is a schematic cross-sectional view showing an example of an apparatus for growing a silicon carbide single crystal with which the inventive method for manufacturing a silicon carbide single crystal can be carried out.

An apparatus 1 for growing a silicon carbide single crystal shown in FIG. 1 with which the inventive method for manufacturing a silicon carbide single crystal can be carried out includes a growth container 4 for housing a seed substrate (seed crystal substrate, seed wafer) 2 and a silicon carbide raw material 3, a heat-insulating material (heat-insulating container) 5 surrounding the growth container 4, a temperature-measurement sensor 7 for measuring the temperature inside the growth container 4 via an upper-portion temperature measurement hole 6 provided in the heat-insulating material 5, and a heater (radio-frequency heating coil) 8 for heating the silicon carbide raw material 3.

The growth container 4 has a growth chamber for disposing the seed substrate 2, and a sublimation chamber for disposing the silicon carbide raw material 3, and is formed of, for example, heat-resistant graphite. In addition, during crystal growth, a crystal is grown in an inert gas atmosphere under reduced pressure by setting the growth container 4 in an external container 9 made of SUS or quartz, and supplying an inert gas such as Ar while vacuum exhausting.

As the heater 8, a heater for performing RH (resistance heating) or RF (radio-frequency) heating can be used. In addition, by using a pyrometer as the temperature-measurement sensor 7, the temperature measurement can be performed with precision through the hole 6 for temperature measurement (upper-portion temperature measurement hole) in the heat-insulating material 5 from outside the growth container 4 without contact. In the present invention, a substrate used as the seed substrate 2 to be disposed inside the growth container 4 has a {0001} plane with an off angle of 1° or less as a surface to be placed on the growth container 4, and a convex-shaped end face of a grown ingot (top crystal) as a single crystal growth surface. Note that it is sufficient for the placement surface to have the {0001} plane with an off angle of 1° or less, and the lower limit of the off angle can be 0°. Further, the seed (seed crystal substrate) 2 has a diameter which is 80% or more, more preferably 90% or more, of the growth container 4. Note that the upper limit of the diameter of the seed 2 can be as large as 100% of the inner diameter of the growth container 4. Moreover, the thickness at the thickest portion can be 5 mm or more, preferably 1 cm or more.

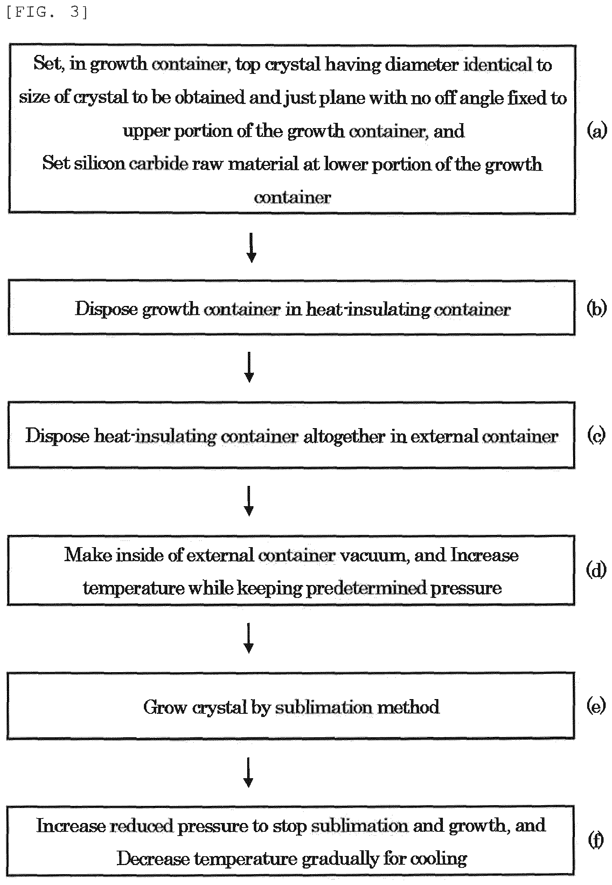

Next, the inventive method for manufacturing a silicon carbide single crystal will be described using FIG. 3.

First, as described in FIG. 3(a), a top crystal is set in the growth container 4. This top crystal has a diameter being the same size as a crystal to be obtained, and has a just plane with no off angle that is fixed to an upper portion of the growth container 4. The silicon carbide raw material 3 is set at a lower portion of the growth container 4.

Next, as described in FIG. 3(b), the growth container 4 is disposed in the heat-insulating container 5.

Next, as described in FIG. 3(c), the heat-insulating container 5 as a whole is disposed in the external container 9.

Next, as described in FIG. 3(d), the inside of the external container 9 is made vacuum, and the temperature is raised to 2000 to 2300°C while a predetermined pressure is being kept (for example, 1 to 20 Torr (1.3 to 26 hPa)).

Next, as described in FIG. 3(e), a silicon carbide single crystal (grown crystal) 2a is grown on the seed crystal (seed crystal substrate) 2 by a sublimation method (see an apparatus 1' for growing a silicon carbide single crystal in FIG. 2).

Finally, as described in FIG. 3(f), the pressure is increased to stop the sublimation and the growth, and the temperature is gradually lowered for cooling.

A SiC single crystal is manufactured in a manner as described above. In the seed crystal substrate, an end face of a grown ingot is used as the growth surface of the single crystal, and the diameter of the seed crystal substrate is 80% or more of the inner diameter of the growth container. These make it possible to manufacture a silicon carbide single crystal with a high straight-body percentage while suppressing formation of different polytypes.

EXAMPLE

Hereinafter, the present invention will be more specifically described by showing Examples and Comparative Examples. However, the present invention is not limited thereto.

(Example 1)

A SiC single crystal with a diameter of 100 mm was grown according to the flow described in FIG. 3 under the following growth conditions.

<Conditions>

Inner diameter of growth container... 105 mm
Seed crystal substrate... a SiC single crystal substrate with the {0001} plane as the main surface, a diameter of 100 mm (the diameter of the seed crystal substrate/the inner diameter of the growth container was 95%), the maximum thickness of 8 mm, and a convex-shaped end face of a grown ingot
Growth temperature... 2200°C
Pressure... 10 Torr (13 hPa)
Atmosphere... argon and nitrogen gases

After the SiC single crystal growth, the straight-body percentage (straight body/full length) was measured and found to be 90%. Moreover, a wafer cut out with a multi-wire saw was ground, mirror-polished, and CMP polished. Then, the surface of the wafer was observed. As shown in FIG. 4, no formation of different polytypes was found. Further, crystals were prepared, resulting in five batches in total. These results were shown in Tables 1, 2. As shown in Tables 1 and 2, no different polytypes were formed in all the five batches (i.e., the incidence of different polytypes was 0%).

[Table 1]

|  | Number of incidences of different polytypes | Number of growths | Straight-body percentage |
|---|---|---|---|
| Example 1 | 0 | N=5 | 90% |
| Comparative Example 1 | 10 | N=10 | - |
| Comparative Example 2 | 0 | N=5 | 40% |

[Table 2]

|  | Diameter of seed crystal substrate/ inner diameter of growth container (%) | Incidences of different polytypes (%) | Number of growths |
|---|---|---|---|
| Example 1 | 95 | 0 | N=5 |
| Example 2 | 80 | 0 | N=5 |
| Comparative Example 3 | 75 | 20 | N=10 |
| Comparative Example 4 | 50 | 30 | N=10 |
| Comparative Example 5 | 20 | 50 | N=10 |

(Example 2)

A SiC single crystal was grown under the same conditions as in Example 1, except for using a seed crystal substrate with a diameter of 84 mm (the diameter of the seed crystal substrate/the inner diameter of the growth container was 80%).

After the SiC single crystal growth, the straight-body percentage (straight body/full length) was measured and found to be 85%. After the SiC single crystal growth, a wafer cut out with a multi-wire saw was ground, mirror-polished, and CMP polished. Then, the surface of the wafer was observed, and no formation of different polytypes was found. Further, crystals were prepared, resulting in five batches in total. Table 2 shows the result. As shown in Table 2, no different polytypes were formed in all the five batches (i.e., the incidence of different polytypes was 0%).

(Comparative Example 1)

A SiC single crystal was grown under the same conditions as in Example 1, except for using a seed (seed crystal substrate) with the main surface being the {0001} plane and a thickness of 1 mm (uniform).

Crystals were prepared, resulting in ten batches in total. Table 1 shows the result. As shown in Table 1, different polytypes were formed and all the ten batches were disordered.

(Comparative Example 2)

A SiC single crystal was grown under the same conditions as in Example 1, except for using a seed (seed crystal substrate) with the main surface being tilted by 4° from the {0001} plane in the <11-20> direction and a thickness of 1 mm (uniform).

After the SiC single crystal growth, the straight-body percentage (straight body/full length) was measured and found to be 40%. Crystals were prepared, resulting in five batches in total. Table 1 shows the result. As shown in Table 1, no different polytypes were formed in all the five batches.

(Comparative Example 3)

A SiC single crystal was grown under the same conditions as in Example 1, except for using a seed crystal substrate with a diameter of 79 mm (the diameter of the seed crystal substrate/the inner diameter of the growth container was 75%).

After the SiC single crystal growth, a wafer cut out with a multi-wire saw was ground, mirror-polished, and CMP polished. Then, the surface of the wafer was observed. Further, crystals were prepared, resulting in ten batches in total. Table 2 shows the result. As shown in Table 2, the formation of different polytypes was observed in two batches out of the ten batches (i.e., the incidence of different polytypes was 20%).

(Comparative Example 4)

A SiC single crystal was grown under the same conditions as in Example 1, except for using a seed crystal substrate with a diameter of 52 mm (the diameter of the seed crystal substrate/the inner diameter of the growth container was 50%).

After the SiC single crystal growth, a wafer cut out with a multi-wire saw was ground, mirror-polished, and CMP polished. Then, the surface of the wafer was observed. Further, crystals were prepared, resulting in ten batches in total. Table 2 shows the result. As shown in Table 2, the formation of different polytypes was observed in three batches out of the ten batches (i.e., the incidence of different polytypes was 30%).

(Comparative Example 5)

A SiC single crystal was grown under the same conditions as in Example 1, except for using a seed crystal substrate with a diameter of 21 mm (the diameter of the seed crystal substrate/the inner diameter of the growth container was 20%).

After the SiC single crystal growth, a wafer cut out with a multi-wire saw was ground, mirror-polished, and CMP polished. Then, the surface of the wafer was observed. Further, crystals were prepared, resulting in ten batches in total. Table 2 shows the result. As shown in Table 2, the formation of different polytypes was observed in five batches out of the ten batches (i.e., the incidence of different polytypes was 50%).

Table 2 reveals that when the diameter of the seed crystal substrate is as large as 80% or more of the inner diameter of the growth container, the formation of different polytypes is sufficiently suppressed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

**Claims**

1. A method for manufacturing a silicon carbide single crystal by sublimating a silicon carbide raw material in a growth container to grow a silicon carbide single crystal on a seed crystal substrate, wherein
a substrate used as the seed crystal substrate comprises:

   a {0001} plane with an off angle of 1° or less as a surface to be placed on the growth container; and
   a convex-shaped end face of a grown ingot as a crystal growth surface, and

   a diameter of the seed crystal substrate is 80% or more of an inner diameter of the growth container.

[FIG. 1]

[FIG. 2]

[FIG. 3]

```
┌─────────────────────────────────────────────────────────────┐
│   Set, in growth container, top crystal having diameter      │
│   identical to                                               │
│  size of crystal to be obtained and just plane with no off   │
│  angle fixed to                                          (a) │
│          upper portion of the growth container, and          │
│    Set silicon carbide raw material at lower portion of the  │
│                         growth                               │
│                        container                             │
└─────────────────────────────────────────────────────────────┘
                              ↓
┌─────────────────────────────────────────────────────────────┐
│      Dispose growth container in heat-insulating container   │  (b)
└─────────────────────────────────────────────────────────────┘
                              ↓
┌─────────────────────────────────────────────────────────────┐
│  Dispose heat-insulating container altogether in external    │  (c)
│  container                                                   │
└─────────────────────────────────────────────────────────────┘
                              ↓
┌─────────────────────────────────────────────────────────────┐
│     Make inside of external container vacuum, and Increase   │  (d)
│     temperature while keeping predetermined pressure         │
└─────────────────────────────────────────────────────────────┘
                              ↓
┌─────────────────────────────────────────────────────────────┐
│           Grow crystal by sublimation method                 │  (e)
└─────────────────────────────────────────────────────────────┘
                              ↓
┌─────────────────────────────────────────────────────────────┐
│   Increase reduced pressure to stop sublimation and growth,  │  (f)
│   and                                                        │
│       Decrease temperature gradually for cooling             │
└─────────────────────────────────────────────────────────────┘
```

[FIG. 4]

[FIG. 5]

[FIG. 6]

[FIG. 7]

[FIG. 8]

[FIG. 9]

[FIG. 10]

| Dispose silicon carbide raw material and just-plane seed substrate having uniform thickness in growth container | (a) |

↓

| Dispose growth container in heat-insulating container | (b) |

↓

| Dispose heat-insulating container altogether in external container | (c) |

↓

| Make inside of external container vacuum, and Increase temperature while keeping predetermined pressure | (d) |

↓

| Grow crystal by sublimation method | (e) |

↓

| Increase reduced pressure to stop sublimation and growth, and Decrease temperature gradually for cooling | (f) |

[FIG. 11]

## INTERNATIONAL SEARCH REPORT

International application No.

PCT/JP2019/005730

### A. CLASSIFICATION OF SUBJECT MATTER
Int.Cl. C30B29/36(2006.01)i, C30B23/06(2006.01)i
According to International Patent Classification (IPC) or to both national classification and IPC

### B. FIELDS SEARCHED

Minimum documentation searched (classification system followed by classification symbols)
Int.Cl. C30B29/36, C30B23/06

Documentation searched other than minimum documentation to the extent that such documents are included in the fields searched

| | |
|---|---|
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2010-126380 A (BRIDGESTONE CORPORATION) 10 June 2010, claims, paragraphs [0082]-[0089], fig. 3 (Family: none) | 1 |
| Y | JP 2015-86114 A (FUJIKURA LTD.) 07 May 2015, paragraphs [0044]-[0057] (Family: none) | 1 |
| A | JP 2006-225232 A (NIPPON STEEL CORP.) 31 August 2006, entire text (Family: none) | 1 |

☐ Further documents are listed in the continuation of Box C.　☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 02 April 2019 (02.04.2019) | 09 April 2019 (09.04.2019) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000191399 A
- JP 2005239465 A

- JP 2010126380 A